# EUROPÄISCHE PATENTANMELDUNG

(11) **EP 4 632 626 A1**
(43) Veröffentlichungstag der Anmeldung: **15.10.2025**
(21) Anmeldenummer: 25164636.0
(22) Anmeldetag: 19.03.2025
(51) Int. Cl.: G06K 7/10, G01D 3/028, G01D 11/24, G01V 8/10, G12B 15/06, H05K 7/20

(54) **OPTISCHER SENSOR**

(30) Priorität: 10.04.2024 DE 202024101732 U
(71) Anmelder: Leuze electronic GmbH + Co. KG, 73277 Owen/Teck (DE)
(72) Erfinder: Droemer, Jörg, 72574 Bad Urach-Wittlingen (DE); Kharrazian Dr., Reza, 72762 Reutlingen (DE); Dümmel, Thomas, 72584 Hülben (DE)
(74) Vertreter: Ruckh, Rainer Gerhard

(57) **Zusammenfassung**

Die Erfindung betrifft einen optischen Sensor (1) mit einem Gehäuse (2), in welchem wenigstens eine für eine Objekterfassung ausgebildete Sensorkomponente sowie Elektronikkomponenten angeordnet sind. Wenigstens eine Elektronickomponente generiert abhängig von Sensorsignalen der Sensorkomponente ein Ausgangssignal. Die aus wärmeleitfähigem Material bestehende Abschnitte des Gehäuses (2) sind über Wärmeleitschichten (15) mit einer Elektronikkomponente und/oder der Sensorkomponente verbunden, so dass in diesen generierte Wärme über das Gehäuse (2) nach außen abgeführt wird.

## Beschreibung

Die Erfindung betrifft einen optischen Sensor.

Derartige optische Sensoren werden generell zur Erfassung von Objekten eingesetzt. Hierzu weist der optische Sensor in einem Gehäuse integrierte Sensorkomponenten und Elektronikkomponenten auf.

Typischerweise weist der optische Sensor als Sensorkomponenten eine Lichtstrahlen emittierende Sendereinheit und eine Empfängereinheit auf, die von einem Objekt rückreflektierte Lichtstrahlen empfängt.

Wenigstens eine der Elektronikkomponenten bildet eine Auswerteeinheit, in welcher in Abhängigkeit von Sensorsignalen der Sensorkomponente ein Ausgangssignal generiert wird.

Der optische Sensor kann zur Erfassung von Objekten in einem Überwachungsbereich eingesetzt werden. In diesem Fall generiert der optische Sensor als Ausgangssignal ein Objektfeststellungssignal welches signalisiert, ob ein Objekt im Überwachungsbereich vorhanden ist oder nicht.

Der optische Sensor kann insbesondere auch zur Erfassung von Codes, wie z.B. Barcodes oder 2D-Codes, eingesetzt werden, d.h. der optische Sensor bildet dann einen Codeleser. In diesem Fall werden in der Auswerteeinheit die in den Sensorsignalen der Empfängereinheit enthaltenen Codeinformationen dekodiert, so dass als Ausgangssignal der erfasste Code ausgegeben werden kann.

Insbesondere bei einer Ausführungsform in Form eines Codelesers ist die Empfängereinheit in Form eines Bildsensors, d.h. eines Imagers, ausgebildet. Vorteilhaft ist dem Bildsensor eine Sendereinheit in Form einer Beleuchtungseinheit zugeordnet, die beispielsweise eine Mehrfachanordnung von Leuchtdioden aufweist.

Der Bildsensor ist vorteilhaft durch MIPI-Leitungen mit einer die Auswerteeinheit bildenden Rechnereinheit verbunden. MIPI-Leitungen sind von dem MIPI-Konsortium genormte serielle Schnittstellen-Leitungen, die hohe und schnelle Datenübertragungsraten aufweisen.

Ein Problem hierbei besteht darin, dass derartige MIPI-Leitungen bei größeren Längen eine hohe Störanfälligkeit aufweisen.

Ein weiteres generelles Problem besteht bei optischen Sensoren darin, dass deren Innenraum durch die Heizleistungen der Elektronikkomponenten und Sensorkomponenten aufgeheizt wird, was zu Funktionsbeeinträchtigungen oder sogar zu Ausfällen des optischen Sensors führen kann.

Der Erfindung liegt die Aufgabe zugrunde einen optischen Sensor der eingangs genannten Art so auszubilden, dass dieser eine geringe Störanfälligkeit aufweist.

Zur Lösung dieser Aufgabe sind die Merkmale des Anspruchs 1 vorgesehen. Vorteilhafte Ausführungsformen und zweckmäßige Weiterbildungen der Erfindung sind in den abhängigen Ansprüchen beschrieben.

Die Erfindung betrifft einen optischen Sensor mit einem Gehäuse, in welchem wenigstens eine für eine Objekterfassung ausgebildete Sensorkomponente sowie Elektronikkomponenten angeordnet sind. Wenigstens eine Elektronikkomponente generiert abhängig von Sensorsignalen der Sensorkomponente ein Ausgangssignal. Aus wärmeleitfähigem Material bestehende Abschnitte des Gehäuses sind über Wärmeleitschichten mit einer Elektronikkomponente und/oder der Sensorkomponente verbunden, so dass in diesen generierte Wärme über das Gehäuse nach außen abgeführt wird.

Ein wesentlicher Vorteil der Erfindung besteht darin, dass im Innenraum aufgrund der Heizleistungen der Sensorkomponenten und Elektronikkomponenten entstehende Wärme über das Gehäuse effizient nach außen, d.h. an die Umgebung des optischen Sensors, abgeleitet werden kann. Dadurch können Überhitzungen der Elektronikkomponenten und Sensorkomponenten und dadurch bedingte Fehlfunktionen oder sogar Ausfälle des optischen Sensors vermieden werden. Dieser Effekt kann dadurch noch verstärkt werden, wenn die Außenseite des Gehäuses mit wärmeabstrahlender Farbe lackiert ist.

Ein wesentlicher Aspekt der Erfindung besteht dabei darin, dass das Gehäuse komplett oder zumindest abschnittsweise aus einem wärmeleitfähigen Material, d.h. einem Material mit hoher Wärmeleitfähigkeit, besteht. Dadurch kann Wärme über Wärmeleitung über das Gehäuse des optischen Sensors nach außen abgeführt werden.

Ein weiterer wesentlicher Aspekt der Erfindung besteht darin, dass die Gehäusestruktur des Gehäuses des optischen Sensors derart ausgebildet ist, dass Gehäusesegmente direkt an Elektronikkomponenten und/oder Sensorkomponenten heranreichen und mit diesen über dünne Wärmeleitschichten verbunden sind. Damit wird ein direkter Wärmeübergang von der Elektronikkomponente bzw. Sensorkomponente über die Wärmeleitschicht auf das Gehäusesegment und damit das gesamte Gehäuse erzielt, der für eine direkte Abfuhr von Wärme, die im Bereich der Elektronikkomponente oder der Sensorkomponente entsteht, sorgt.

Das oder die Gehäusesegmente können von Innenseiten von Gehäusewänden des Gehäuses hervorstehen und von dort direkt an den Elektronikkomponenten oder Sensorkomponenten geführt sein.

Besonders vorteilhaft besteht das Gehäuse aus einem wärmeleitfähigen metallischen Werkstoff.

Metallische Werkstoffe weisen sehr hohe Wärmeleitfähigkeitswerte auf und eignen sich somit besonders gut zur Ableitung von Wärme aus dem Innenraum des Gehäuses.

Gemäß einer vorteilhaften Ausgestaltung ist der metallische Werkstoff ein Zink- oder Aluminium-Druckguss.

Gehäuse aus Zink- oder Aluminium-Druckgussteilen können rationell gefertigt werden. Zudem ist vorteilhaft, dass damit auch komplexe Gehäusegeometrien realisiert werden können.

Die Wärmeleitschichten weisen generell geringe Schichtdicken auf, die vorteilhaft im µm-Bereich liegen. Dies gewährleistet gute Wärmeübergänge zu den Gehäusestrukturen.

Vorteilhaft ist als Wärmeleitschicht ein Wärmeleit-Pad oder eine Wärmeleit-Paste vorgesehen.

Die Leiterplatte als flächiges, großes Bauteil generiert eine beträchtliche Wärme während des Betriebs des optischen Sensors, insbesondere auch auf der Leiterplatte vorhandene weitere Elektronikkomponenten.

Durch die direkte Ankopplung der Leiterplatte über die Wärmeleitschichten an den Gehäusedeckel oder eine Gehäusewand, die jeweils wärmeleitend sind, kann effizient Wärme, die im Bereich der Leiterplatte entsteht, aus dem Innenraum des Gehäuses abgeführt werden.

Generell kann direkt die Oberfläche der Leiterplatte selbst oder die Oberfläche einer weiteren, auf der Leiterplatte platzierten Elektronikkomponente, mit der Wärmeleitschicht verbunden sein.

Gemäß einer weiteren vorteilhaften Ausführungsform mündet an Innenseiten von aus wärmeleitendem Material bestehenden Gehäusewandsegmenten ein Kühlkörper aus, der aus wärmeleitfähigem Material besteht und Bestandteil des Gehäuses ist, d.h. er ist einstückig mit dem Gehäuskörper des Gehäuses, das eine Umhausung für Sensor- und Elektronikkomponenten bildet, ausgebildet. Alternativ kann der Kühlkörper mit dem Gehäusekörper wärmeleitend verbunden sein, beispielsweise über eine Schraubverbindung. Der Kühlkörper ist über wenigstens eine Wärmeleitschicht in Kontakt mit wenigstens einer Elektronikkomponente.

Insbesondere ist der Kühlkörper über wenigstens eine Wärmeleitschicht in Kontakt mit der Oberseite der Leiterplatte.

Die Geometrie des Kühlkörpers als Bestandteil des Gehäuses ist derart optimiert, dass dieser direkt an zu kühlende Sensorkomponenten einer Elektronikkomponente, insbesondere an die Leiterplatte, herangeführt ist, so dass über diesen direkt Wärme abgeleitet und über die Gehäusewand nach außen abgeführt werden kann.

Der Kühlkörper ist hierzu hinreichend großflächig, so dass mit diesem große Wärmemengen abgeleitet werden können.

Auch in diesem Fall kann die Wärmeleitschicht direkt mit einer Oberfläche der Leiterplatte oder einer darauf platzierten weiteren Elektronikkomponente sein.

Gemäß einer vorteilhaften Ausführungsform sind bei dem optischen Sensor als Sensorkomponenten ein Bildsensor und ein Objektiv vorhanden.

Der Bildsensor, d.h. Imager, kann beispielsweise von einem matrixförmigen CMOS- oder CCD-Array gebildet sein, das Objektiv besteht in bekannter Weise aus einer Linsenanordnung.

In diesem Fall kann der optische Sensor als Codeleser ausgebildet sein, mit dem Barcodes und 2D-Codes erfasst werden können.

Vorteilhaft sind der Bildsensor und das Objektiv auf der Oberseite der Leiterplatte gelagert.

Vorteilhaft weist der Kühlkörper Kühlrippen auf, die radial auf das den Bildsensor umschließende Objektiv zulaufen.

Dabei sind das Objektiv und der Bildsensor in einen Tubus gelagert, der mittels der Kühlrippen lagefixiert ist.

Der Kühlkörper mit den Kühlrippen erfüllt somit eine Doppelfunktion derart, dass dieser nicht nur zur Wärmeableitung dient, sondern auch zur Lagefixierung des Objektivs mit dem Bildsensor.

Zweckmäßig ist der Tubus durch eine Klemmverbindung oder eine Schraubverbindung mit den Kühlrippen verbunden.

Beide Varianten führen zu einer sicheren Lagefixierung des Tubus.

Gemäß einer vorteilhaften Ausgestaltung weist der Kühlkörper Zentrierstifte auf, die in Bohrungen der Leiterplatte einführbar sind.

Dabei ist mittels der Zentrierstifte der Bildsensor mit dem Objektiv relativ zu einer eine Kameraaufnahme bildenden Bohrung in der Leiterplatte positioniert.

Die Bohrungen werden vorab, insbesondere durch Bildverarbeitungsunterstützung, in Sollposition in die Leiterplatte eingearbeitet, so dass anschließend durch Einführen der Zentrierstifte eine hochgenaue Positionierung des Bildsensors in der Kameraaufnahme gewährleistet ist.

Gemäß einer optionalen Ausgestaltung sind auf der Oberseite der Leiterplatte Sensorkomponenten in Form von Lichtstrahlen emittierende Leuchtdioden gelagert, die eine Beleuchtungseinheit ausbilden.

Die Beleuchtungseinheiten sind somit auf derselben Seite der Leiterplatte wie der Bildsensor mit dem Objektiv angeordnet, vorzugsweise direkt benachbart zu diesen. Mit den Lichtstrahlen, die von den Leuchtdioden emittiert werden, wird das Sichtfeld des Bildsensors ausgeleuchtet.

Vorteilhaft liegen die Leuchtdioden in Aussparungen der Kühlrippen.

Die Aussparungen des Kühlkörpers erfüllen eine Blendenfunktion und verhindern ein Übersprechen, d.h. direktes Einstrahlen der Lichtstrahlen der Leuchtdioden in das Objektiv und den Bildsensor.

Weiterhin kann der Kühlkörper eine Zusatzfunktion derart erfüllen, dass dieser eine Linsenplatte trägt, die zur Strahlformung der von den Leuchtdioden emittierten Lichtstrahlen dient.

Gemäß einer vorteilhaften Ausführungsform ist auf der Unterseite eine eine Elektronikkomponente bildende Rechnereinheit gelagert, die eine Auswerteeinheit bildet, in der das Ausgangssignal generiert wird. Die Rechnereinheit und der Bildsensor sind beidseits der Leiterplatte gegenüberliegend angeordnet.

Insbesondere ist die Rechnereinheit ein Microcontroller.

Die Positionierung der Rechnereinheit an der Unterseite der Leiterplatte ist an die Positionierung des Bildsensors an der Oberseite optimal angepasst, so dass der Bildsensor über sehr kurze Leitungen an die Rechnereinheit angeschlossen werden kann.

Das ist insbesondere dann vorteilhaft, wenn die Rechnereinheit und der Bildsensor über MIPI-Leitungen verbunden sind.

Dadurch, dass die MIPI-Leitungen sehr kurz ausgebildet sein können, werden unerwünschte Störungen bei der Datenübertragung über diese MIPI-Leitungen vermieden.

Die Erfindung wird im Folgenden anhand der Zeichnungen erläutert. Es zeigen:
- Figur 1:: Ausführungsbeispiel des erfindungsgemäßen optischen Sensors.
- Figur 2:: Einzeldarstellung von Komponenten des optischen Sensors gemäß Figur 1.
- Figur 3:: Schematische Schnittdarstellung des optischen Sensors gemäß Figur 1.

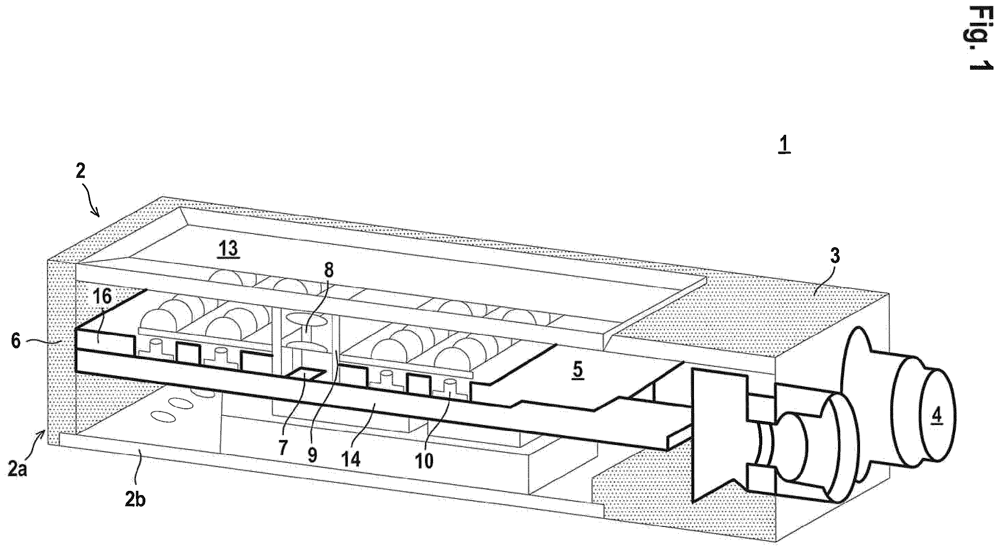

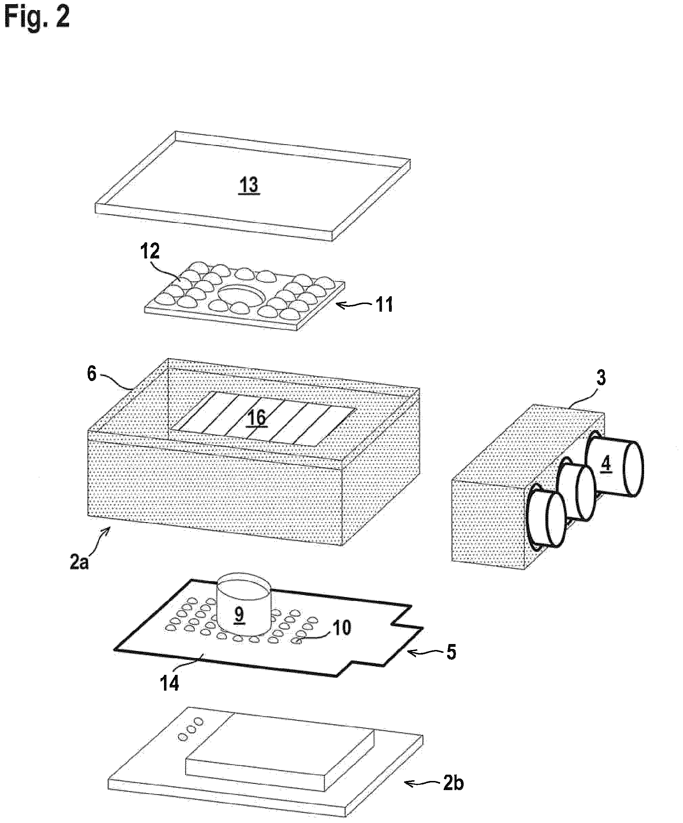

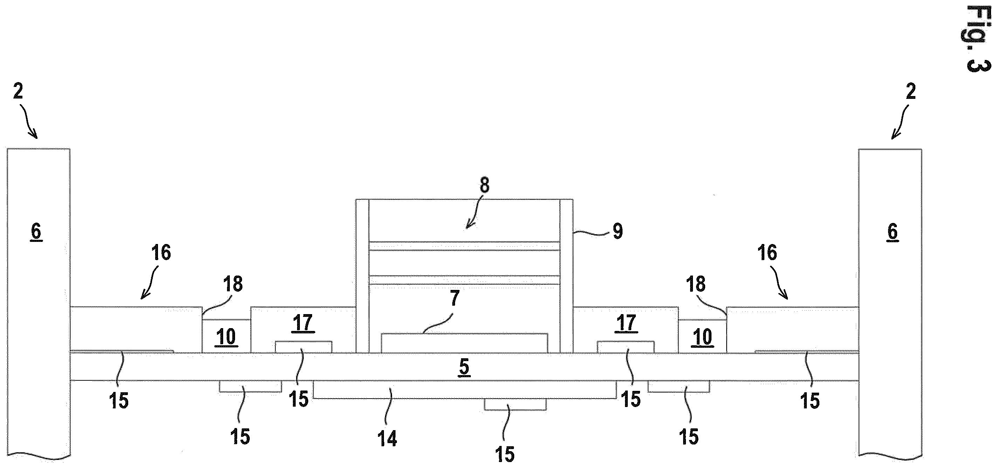

Figur 1 zeigt ein Ausführungsbeispiel des erfindungsgemäßen optischen Sensors 1. Komponenten des optischen Sensors sind in Figur 2 dargestellt. Figur 3 ist eine stark schematische, nicht maßstäbliche Schnittdarstellung des optischen Sensors 1 entlang einer Schmalseite des optischen Sensors 1.

Der optische Sensor 1 ist im vorliegenden Fall als Codeleser ausgebildet, mit welchem Barcodes und 2D-Codes erfasst und dekodiert werden können.

Der optische Sensor 1 weist ein Gehäuse 2 auf, in welchem die Elektronikkomponenten und Sensorkomponenten des optischen Sensors 1 integriert sind. Das Gehäuse 2 besteht aus einem Material mit hoher Wärmeleitfähigkeit. Hierzu besteht das Gehäuse 2 aus einem metallischen Werkstoff. Im vorliegenden Fall besteht das Gehäuse 2 aus zwei Zink- oder Aluminium-Druckgussteilen, nämlich einem Gehäusekörper 2a und einem Gehäusedeckel 2b, der eine Öffnung an der Unterseite des Gehäusekörpers 2a abschließt.

Seitlich am Gehäusekörper 2a ist eine Steckerhaube 3 mit elektrischen Anschlüssen 4 befestigt. Auch die Steckerhaube 3 kann aus einem Zink- oder Aluminium-Druckgussteil bestehen.

Als zentrale Elektronikkomponente ist eine Leiterplatte 5 vorhanden, die an Innenseiten von Gehäusewänden 6 des Gehäuses 2 befestigt ist.

Auf der Oberseite der Leiterplatte 5 sind als Sensorkomponenten ein Bildsensor 7 und ein diesem zugeordnetes Objektiv 8 gelagert. Das Objektiv 8 ist in einem Tubus 9 untergebracht, der auf der Oberseite der Leiterplatte 5 befestigt ist. Der Tubus 9 besteht aus lichtundurchlässigem Material und ist an seiner Oberseite offen.

Der Bildsensor 7 besteht vorteilhaft aus einem matrixförmigen CCD- oder CMOS-Array. Das Objektiv 8 besteht aus einer Anordnung von Linsen.

Auf der Oberseite der Leiterplatte 5 sind weiterhin Lichtstrahlen emittierende Leuchtdioden 10 gelagert, die eine Beleuchtungseinheit ausbilden. Mit den Lichtstrahlen der Beleuchtungseinheit wird das Sichtfeld des Bildsensors 7 ausgeleuchtet.

Den Leuchtdioden 10 ist eine Linsenplatte 11 mit Linsenelementen 12 zugeordnet, mittels derer eine Strahlformung der Lichtstrahlen erfolgt.

In eine Öffnung an der Oberseite des Gehäuses 2 ist ein für die Lichtstrahlen transparentes Fenster 13 eingesetzt.

An der Unterseite der Leiterplatte 5 ist ein Microcontroller 14 gelagert, der eine Rechnereinheit und damit eine Elektronikkomponente des optischen Sensors 1 bildet. Anstelle des Microcontrollers 14 können auch andere Prozessoren vorgesehen sein. Der Microcontroller 14 liegt dem Bildsensor 7 direkt gegenüber. Der Bildsensor 7 ist mittels nicht dargestellter MIPI-Leitungen an den Microcontroller 14 angeschlossen. Über die MIPI-Leitungen werden Sensorsignale des Bildsensors 7 in den Microcontroller 14 eingelesen, der eine Auswerteeinheit zur Auswertung der Sensorsignale bildet.

Zur Erfassung von Codes werden die Lichtstrahlen der Leuchtdioden 10 über das Fenster 13 aus dem optischen Sensor 1 in einen Erfassungsbereich geführt. Von einem Code reflektierte Lichtstrahlen werden über die Scheibe und das Objektiv 8 zum Bildsensor 7 geführt. Die dabei im Bildsensor 7 generierte Sensorsignale, die die Codeinformationen des Codes enthalten, werden im Microcontroller 14 zur Dekodierung des Codes ausgewertet. Der dekodierte Code wird vom optischen Sensor als Ausgangssignal ausgegeben.

Erfindungsgemäß dient das aus wärmeleitfähigem Material bestehende Gehäuse 2 zur Ableitung von Wärme aus dem Innenraum des optischen Sensors 1.

Hierzu sind Abschnitte des Gehäuses 2 über Wärmeleitschichten 15 direkt, d.h. ohne dazwischen liegende Luftspalte, mit Elektronikkomponenten oder Sensorkomponenten verbunden, so dass dort entstehende Wärme über die Wärmeleitschicht 15 und das Gehäuse 2 abgeleitet und nach außen, d.h. in die Umgebung des optischen Sensors 1 geführt wird.

Die Wärmeleitschichten 15 weisen Schichtdicken im µm-Bereich auf und können aus Wärmeleit-Pads oder aus Wärmeleit-Pasten bestehen.

Im vorliegenden Fall erfolgt über Wärmeleitschichten 15 an der Unterseite der Leiterplatte 5 bzw. des Microcontrollers 14 eine direkte Kontaktierung des Gehäusedeckels 2b, so dass in der Leiterplatte 5 bzw. im Microcontroller 14 generierte Wärme über die dort vorhandenen Wärmeleitschichten 15 und den mit den Wärmeleitschichten 15 in Kontakt stehendem Gehäusedeckel 2b nach außen abgeführt wird.

Weiterhin ist an Innenseiten von Gehäusewänden 6 ausmündend ein Kühlkörper 16 vorgesehen, der einstückig mit diesen Gehäusewänden 6 ausgebildet ist und Bestandteil des Gehäusekörpers 2a ist. Alternativ kann der Kühlkörper 16 wärmeleitend mit dem Gehäusekörper 2a verbunden sein.

Der Kühlkörper 16 verläuft in einer Ebene senkrecht zu den Gehäusewänden 6, an welchen dieser ausmündet. Der Kühlkörper 16 ist so dimensioniert, dass er auf der Leiterplatte 5 flächig aufliegt, wobei zwischen der Leiterplatte 5 und dem Kühlkörper 16 weitere Wärmeleitschichten 15 vorhanden sind. Damit wird im Bereich der Leiterplatte 5 entstehende Wärme direkt über die Wärmeleitschichten 15, den Kühlkörper 16 und die Gehäusewände 6 nach außen abgeführt.

Der Kühlkörper 16 weist radial auf den Tubus 9 zulaufende Kühlrippen 17 auf. Die Kühlrippen 17 dienen zur Lagefixierung des Tubus 9, wobei der Tubus 9 mittels einer Klemmverbindung an den Kühlrippen 17 fixiert ist. Alternativ kann der Kühlkörper 16 ein ringförmiges Segment mit einem Innengewinde ausbilden, in welches der Tubus 9 eingeschraubt wird.

Wie insbesondere aus Figur 3 ersichtlich, weist der Kühlkörper 16 Aussparungen 18 auf, in welchen die Leuchtdioden 10 gelagert sind. Im Bereich der Aussparungen 18 können weitere (nicht dargestellte) Wärmeleitschichten 15 vorhanden sein, die eine wärmeleitende Verbindung zwischen den Leuchtdioden 10 und dem Kühlkörper 16 schaffen.

Gemäß einer vorteilhaften Weiterbildung kann der Kühlkörper 16 Zentrierstifte aufweisen, die in Bohrungen der Leiterplatte 5 einführbar sind.

Dabei ist mittels der Zentrierstifte der Bildsensor 7 mit dem Objektiv 8 relativ zu einer eine Kameraaufnahme bildenden Bohrung in der Leiterplatte 5 positioniert.

Die Zentrierstifte und die Bohrungen sind in den Figuren nicht dargestellt.

### Bezugszeichenliste

- (1): Optischer Sensor
- (2): Gehäuse
- (2a): Gehäusekörper
- (2b): Gehäusedeckel
- (3): Steckerhaube
- (4): Anschluss
- (5): Leiterplatte
- (6): Gehäusewand
- (7): Bildsensor
- (8): Objektiv
- (9): Tubus
- (10): Leuchtdiode
- (11): Linsenplatte
- (12): Linsenelement
- (13): Fenster
- (14): Microcontroller
- (15): Wärmeleitschicht
- (16): Kühlkörper
- (17): Kühlrippe
- (18): Aussparung

## Patentansprüche

1. Optischer Sensor (1) mit einem Gehäuse (2), in welchem wenigstens eine für eine Objekterfassung ausgebildete Sensorkomponente sowie Elektronikkomponenten angeordnet sind, wobei wenigstens eine Elektronikkomponente abhängig von Sensorsignalen der Sensorkomponente ein Ausgangssignal generiert, **dadurch gekennzeichnet, dass** aus wärmeleitfähigem Material bestehende Abschnitte des Gehäuses (2) über Wärmeleitschichten (15) mit einer Elektronikkomponente und/oder der Sensorkomponente verbunden sind, so dass in diesen generierte Wärme über das Gehäuse (2) nach außen abgeführt wird.

2. Optischer Sensor (1) nach Anspruch 1, **dadurch gekennzeichnet, dass** das Gehäuse (2) aus einem wärmeleitfähigen metallischen Werkstoff besteht, und/oder dass als Wärmeleitschicht (15) ein Wärmeleit-Pad oder eine Wärmeleit-Paste vorgesehen ist.

3. Optischer Sensor (1) nach Anspruch 2, **dadurch gekennzeichnet, dass** der metallische Werkstoff ein Zink- oder Aluminium-Druckguss ist.

4. Optischer Sensor (1) nach einem der Ansprüche 1 bis 3, **dadurch gekennzeichnet, dass** als Elektronikkomponente eine Leiterplatte (5) vorhanden ist, deren Unterseite über wenigstens eine Wärmeleitschicht (15) mit einem aus wärmeleitfähigem Material bestehenden Gehäusedeckel (2b) oder einer aus wärmeleitfähigem Material bestehenden Gehäusewand (6) verbunden ist.

5. Optischer Sensor (1) nach einem der Ansprüche 1 bis 4, **dadurch gekennzeichnet, dass** an Innenseiten von aus wärmeleitendem Material bestehenden Gehäusewandsegmenten ein Kühlkörper (16) ausmündet, der aus wärmeleitfähigem Material besteht und Bestandteil des Gehäuses (2) ist oder mit diesem wärmeleitend verbunden ist, und dass der Kühlkörper (16) über wenigstens eine Wärmeleitschicht (15) in Kontakt mit wenigstens einer Elektronikkomponente ist.

6. Optischer Sensor (1) nach einem der Ansprüche 4 und 5, **dadurch gekennzeichnet, dass** der Kühlkörper (16) über wenigstens eine Wärmeleitschicht (15) in Kontakt mit der Oberseite der Leiterplatte (5) ist.

7. Optischer Sensor (1) nach einem der Ansprüche 1 bis 6, **dadurch gekennzeichnet, dass** als Sensorkomponenten ein Bildsensor (7) und ein Objektiv (8) vorhanden sind.

8. Optischer Sensor (1) nach Anspruch 7, **dadurch gekennzeichnet, dass** der Bildsensor (7) und das Objektiv (8) auf der Oberseite der Leiterplatte (5) gelagert sind, und/oder dass das Objektiv (8) und der Bildsensor (7) in einen Tubus (9) gelagert sind, der mittels der Kühlrippen (17) lagefixiert ist.

9. Optischer Sensor (1) nach einem der Ansprüche 7 oder 8, **dadurch gekennzeichnet, dass** der Kühlkörper (16) Kühlrippen (17) aufweist, die radial auf das den Bildsensor (7) umschließende Objektiv (8) zulaufen, und/oder dass der Tubus (9) durch eine Klemmverbindung oder eine Schraubverbindung mit den Kühlrippen (17) des Kühlkörpers verbunden ist.

10. Optischer Sensor (1) nach einem der Ansprüche 4 und 7, **dadurch gekennzeichnet, dass** der Kühlkörper (16) Zentrierstifte aufweist, die in Bohrungen der Leiterplatte (5) einführbar sind, wobei mittels der Zentrierstifte der Bildsensor (7) mit dem Objektiv (8) relativ zu einer eine Kameraaufnahme bildenden Bohrung in der Leiterplatte (5) positioniert ist.

11. Optischer Sensor (1) nach Anspruch 4 und 5, **dadurch gekennzeichnet, dass** auf der Oberseite der Leiterplatte (5) Sensorkomponenten bildende, Lichtstrahlen emittierende Leuchtdioden (10) gelagert sind, die eine Beleuchtungseinheit ausbilden, wobei Leuchtdioden (10) in Aussparungen (18) der Kühlrippen (17) liegen.

12. Optischer Sensor (1) nach einem der Ansprüche 4 bis 11, **dadurch gekennzeichnet, dass** auf der Unterseite der Leiterplatte (5) eine eine Elektronickomponente bildende Rechnereinheit gelagert ist, die eine Auswerteeinheit bildet, in der das Ausgangssignal generiert wird.

13. Optischer Sensor (1) nach Anspruch 12, **dadurch gekennzeichnet, dass** die Rechnereinheit und der Bildsensor (7) über MIPI-Leitungen verbunden sind.

14. Optischer Sensor (1) nach einem der Ansprüche 1 bis 13, **dadurch gekennzeichnet, dass** die Außenseite des Gehäuses mit wärmeabstrahlender Farbe lackiert ist.

15. Optischer Sensor (1) nach einem der Ansprüche 1 bis 14, **dadurch gekennzeichnet, dass** dieser ein Codeleser ist.
